# EUROPÄISCHE PATENTSCHRIFT

(11) **EP 0 578 012 B1**
(45) Veröffentlichungstag und Bekanntmachung des Hinweises auf die Patenterteilung: **08.03.1995**
(21) Anmeldenummer: 93109541.8
(22) Anmeldetag: 15.06.1993
(51) Int. Cl.: H01S 3/103

(54) **Modulierbare Laserdiode für hohe Frequenzen**
High frequency modulation laser diode
Laser à diode pour la modulation à haute la fréquence

(30) Priorität: 08.07.1992 DE 4222466
(43) Veröffentlichungstag der Anmeldung: 12.01.1994
(73) Patentinhaber: SIEMENS AKTIENGESELLSCHAFT, 80333 München (DE)
(72) Erfinder: Wolf, Thomas Dr., D-81739 München (DE); Thulke, Wolfgang, Dr., D-81737 München (DE)

(56) Entgegenhaltungen:
- EP-A- 0 402 189
- EP-A- 0 487 876
- EP-A- 0 524 459
- APPLIED PHYSICS LETTERS. Bd. 60, Nr. 20, 18. Mai 1992, NEW YORK US Seiten 2472- 2474;T. WOLF ET AL 'Tunable twin guide lasers with flat frequency modulation response by quantum confined Stark effect'
- ELECTRONICS LETTERS. Bd. 23, Nr. 18, 27. August 1987, STEVENAGE, HERTS, GB,Seiten 941 - 942;K. KIHARA ET AL:'high power wide bandwidth 1.55 mumwavelength GaInAsP/InP distributed feedback laser'
- ELECTRONICS LETTERS. Bd. 26, Nr. 13, 21. Juni 1990, STEVENAGE, HERTS, GB Seiten933 - 934;W. THULKE ET AL '1.53 mum DFB laser on semi-insulating substrate with very low threshold current'

## Beschreibung

Die vorliegende Erfindung betrifft eine schnell modulierbare Laserdiode mit flachem Frequenzverlauf des Modulationshubes.

Die direkte Frequenzmodulation von Halbleiterlasern ist ein aussichtsreiches Verfahren der Nachrichtenübertragung in optischen Kommunikationsnetzen, das besonders bei der kohärenten Übertragung angewandt wird. In der einfachsten Form erfolgt die Frequenzmodulation durch eine Variation des Laserstroms. Dadurch wird eine Variation der Ladungsträgerdichte in der aktiven Zone der Laserdiode bewirkt und damit über eine Änderung des optischen Brechungsindexes im Laserresonator eine Variation der Emissionsfrequenz. Allerdings hat eine Stromänderung wegen der damit verbundenen Verlustwärme gleichzeitig auch eine Temperaturänderung zur Folge, die ebenfalls die Emissionsfrequenz beeinflußt. Dieser Einfluß ist stärker als der der Ladungsträger und darüber hinaus entgegengesetzt gerichtet. Da die Temperaturänderung wegen der relativ großen thermischen Zeitkonstanten auf Frequenzen kleiner als 10 MHz beschränkt ist, kommt es zu einer Abhängigkeit des Modulationshubes von der Modulationsfrequenz, wobei ein Minimum des Hubes sowie eine Phasenumkehr bei ca. 1 bis 10 MHz auftreten.

Bei den bisher bekannten modulierbaren Laserdioden für hohe Frequenzen wird der Brechungsindex nicht durch den Laserstrom geändert, sondern durch einen oder mehrere zusätzliche Ströme oder durch Nutzung des Feldeffektes anstelle der Injektion von Ladungsträgern. Laser-Modulator-Strukturen, die die Wirkung der Ladungsträgerinjektion nutzen, sind erstens der mehrfach in der Länge unterteilte DFB-Laser (Distributed-Feedback) und zweitens die TTG-DFB-Laserdiode (Tunable-Twin-Guide).

Beim Drei-Sektionen-DFB-Laser werden die Stromstärken in den verschiedenen Sektionen so kombiniert, daß die nachteilige Wirkung der Verlustwärme kompensiert wird. Da in allen drei Sektionen die Ladungsträgerdichte innerhalb der laseraktiven Schicht variiert wird, in der die Lebensdauer der Ladungsträger durch die induzierte Rekombination sehr kurz ist, sind diese Drei-Sektionen-DFB-Laser bis zu Frequenzen weit über 2,5 GHz modulierbar. Von Nachteil ist jedoch der erhebliche Meß- und Steuerungsaufwand, der zum Ermitteln und Einhalten der geeigneten Arbeitspunkte dieser Laser erforderlich ist.

Beim TTG-DFB-Laser wird die Frequenz durch Ladungsträgerinjektion in eine separate Abstimmschicht moduliert, die sich über die gesamte Laserlänge erstreckt. Die Modulation ist dadurch, daß nur ein Strom variiert werden muß und der Laserstrom im Prinzip unabhängig von der Modulation ist, technisch deutlich einfacher als beim Drei-Sektionen-DFB-Laser. Der Nachteil der Ladungsträgerinjektion in eine separate Schicht ist die inhärente Begrenzung der Modulationsfrequenz auf Werte unter 500 MHz. Sie wird durch die Lebensdauer der Ladungträger verursacht, die in der separaten Schicht deutlich größer ist als in der aktiven Schicht.

Die Modulation des Lichtes durch den Feldeffekt in Potentialtopf-Strukturen (Quantum-Confined-Stark-Effekt) ist im Hinblick sowohl auf die maximale Modulationsfrequenz als auch auf den frequenzunabhängigen Verlauf des Modulationshubs günstiger als die Modulation durch Ladungsträgerinjektion. In bisher verwirklichten Konzepten werden der Laser und die Modulatorschichten longitudinal zueinander integriert. Das ist herstellungstechnisch aufwendig, da die benötigten Potentialtopfstrukturen selektiv außerhalb des eigentlichen Laserbereiches epitaktisch aufwachsen müssen. Dabei sind störende Variationen der Schichtdicke aufgrund der vorhandenen Oberflächenstrukturen nur schwer zu vermeiden.

Bei der Laserstruktur in der Veröffentlichung von T. Wolf u. a."Tunable twin-guide lasers with flat frequency modulation reponse by quantum confined Stark effect" in Appl. Phys. Lett. 60, 2472 - 2474 (1992) wird der Feldeffekt in der Abstimmschicht eines TTG-DFB-Lasers zur Frequenzmodulation genutzt. Die Abstimmschicht besteht dazu aus einer Folge von Potentialtopfschichten (Quantum-Well). Im Unterschied zum konventionellen TTG-DFB-Laser wird dieser Laser außerdem so konzipiert, daß die parasitären Kapazitäten und Induktivitäten minimal werden. Dadurch wird der Modulationshub frequenzunabhängig, und die maximale Modulationsfrequenz liegt bei weit über 2,5 GHz. Die Potentialtopfstrukturen sind bei der transversalen Integration im TTG-DFB-Laser einfacher herzustellen als bei einer longitudinalen Integration.

Eine TTG-Laserdiode mit einem semiisolierendem Substrat ist in EP-A-0 487 876 beschrieben.

Aufgabe der vorliegenden Erfindung ist es, eine verbesserte TTG-DFB-Laserdiode für hohe Frequenzen, insbesondere über 2,5 GHz, anzugeben, bei der die Abhängigkeit des Modulationshubs von der Modulationsfrequenz beseitigt oder zumindest minimiert ist. Außerdem soll der Laser einfach herstellbar und im Betrieb einfach zu steuern sein.

Diese Aufgabe wird mit der Laserdiode mit den Merkmalen des Anspruches 1 gelöst. Weitere Ausgestaltungen ergeben sich aus den abhängigen Ansprüchen.

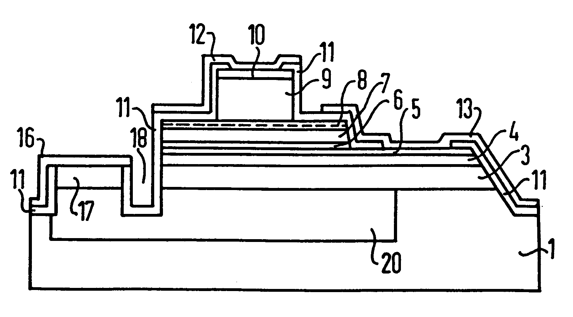

Es folgt eine Beschreibung der erfindungsgemäßen Laserdiode anhand der Figur, die die erfindungsgemäße Laserdiode im Querschnitt zeigt.

Grundlage der erfindungsgemäßen Laserstruktur ist die bekannte Ausführung des TTG-DFB-Lasers als Stegwellenleiter-Laser (Ridge-Waveguide-Laser), wie sie in der angegebenen Veröffentlichung von T. Wolf in Appl. Phys. Lett. beschrieben ist. Die Abstimmdiode, die aus der Abstimmschicht und einer angrenzenden Schicht gebildet wird, wird in Sperrichtung betrieben.

Eine Ausführungsform der erfindungsgemäßen Laserstruktur ist in der Fig. im Querschnitt dargestellt. Auf einem semiisolierenden Substrat 1 befindet sich ein dotierter Bereich 20. Dieser dotierte Bereich 20 ist auf einen schmalen Streifen unterhalb der Abstimmschicht und der aktiven Schicht begrenzt. Bei geeigneter Beschaffenheit der Oberfläche des Substrates 1 kann dieser dotierte Bereich 20 direkt in dem Substrat 1 durch Einbringen von Dotierung hergestellt sein. Statt dessen kann eine dotierte Pufferschicht den dotierten Bereich 20 bilden. Eine solche Pufferschicht mindert die Wirkung von Oberflächendefekten des Substrates 1 und erlaubt es, die Dotierung dieses Bereiches in geeigneter Höhe einzustellen. Das Vorzeichen der Dotierung ist z. B. für p-Leitung gewählt. Auf diesem dotierten Bereich 20 befindet sich eine Schichtfolge, die eine aktive Schicht und eine Abstimmschicht umfaßt. In dem zu beschreibenden Ausführungsbeispiel befindet sich z. B. die Abstimmschicht 3 auf dem dotierten Bereich 20. Diese Abstimmschicht 3 besitzt eine Potentialtopf-Struktur, die aus einer Folge von sehr dünnen Schichten mit abwechselnd größerer und kleinerer Bandlückenenergie besteht. Darauf folgt eine Zentralschicht 5, die in dem in der Figur dargestellten Beispiel zwischen weiteren Kontakt- oder Zwischenschichten 4, 6, die einer Anpassung der Zentralschicht 5 in Gitterstruktur und Dotierungshöhe an die transversal angrenzenden Schichten dienen, angeordnet ist. Diese Kontakt- oder Zwischenschichten 4, 6 können weggelassen sein. Die nachfolgende aktive Schicht 7 der Laserdiode ist in dem Beispiel bedeckt mit einer dotierten DFB-Gitterschicht 8. Diese Gitterschicht 8 kann weggelassen sein. Ein Gitter wird zweckmäßig als geriffelte Grenzfläche zwischen der aktiven Schicht 7 und der Gitterschicht 8 ausgebildet. Auf der Gitterschicht 8, in oder an der das mit der gestrichelten Linie angedeutete Gitter ausgebildet ist, befindet sich ein dotierter Stegwellenleiter 9 mit einer ebenfalls dotierten Kontaktschicht 10. Der dotierte Bereich 20, der Stegwellenleiter 9 und ggf. die DFB-Gitterschicht 8 sind z. B. p-dotiert. Die Zentralschicht 5 und ggf. die Kontakt- oder Zwischenschichten 4, 6 sind z. B. n-dotiert. Die Vorzeichen der Dotierungen können auch umgekehrt sein.

Die Stromzuführung für die aktive Schicht 7 erfolgt über den Stegwellenleitern 9 und die Kontaktschicht 10 bzw. die Zentralschicht 5 mittels der Kontakte 12 und 13. Die Stromzufuhr für die Abstimmschicht 3 erfolgt außer über die Zentralschicht 5 über den dotierten Bereich 20 und einen darauf aufgebrachten weiteren Kontakt 16. Dieser weitere Kontakt 16 für die Abstimmdiode ist auf der Oberseite der Struktur aufgebracht auf einem weiteren dotierten Bereich 17, der z. B. ein Anteil der für die Abstimmschicht 3 aufgebrachten Schichtstruktur sein kann. Die Kontakte 12, 13, 16 befinden sich mit dem größten Teil der Flächen auf dem semiisolierenden Substrat 1, so daß die parasitären Kapazitäten minimal sind. Der weitere dotierte Bereich 17 ist von den restlichen Schichten, insbesondere der Abstimmschicht 3, durch einen flachen Graben 18 und die Passivierungsschicht 11 elektrisch isoliert.

Bei der beschriebenen Ausführungsform können die Schichten 3 und 7 vertauscht sein. Die Schicht 3 ist in dem Fall die aktive Schicht und die Schicht 7 die Abstimmschicht. Die Gitterschicht 8 fehlt entweder oder ist benachbart zu der Schicht 3 angeordnet.

Die wesentlichen Vorteile der vorliegenden Erfindung ergeben sich aus dem wesentlichen Merkmal der Potentialtopfstruktur der Abstimmschicht und auch aus der streifenförmigen seitlichen Begrenzung für die Minimierung der parasitären Kapazitäten. Der von den Schichten 2 bis 5 gebildete Steifen ist bei vorteilhaften Ausführungsformen maximal etwa 40 »m breit. Die Flanken des Stegwellenleiters 9, ggf. die Oberfläche der Gitterschicht 8 und die Flanken der restlichen Schichten, insbesondere in dem Graben 18 sind mit vorteilhaft z. B. mit einer Passivierungsschicht 11 bedeckt. Diese Passivierungsschicht 11 ist auf dem Stegwellenleiter 9 unterbrochen, so daß die Kontaktschicht 10 mit dem Kontakt 12 in Verbindung ist. Die Minimierung der parasitären Kapazitäten resultiert aus der seitlichen Begrenzung der Schichten 2 bis 8 und aus dem großen Abstand zwischen den Kontakten.

## Patentansprüche

1. Abstimmbare Laserdiode,
bei der auf einem Substrat (1) aus semiisolierendem Halbleitermaterial eine aktive Schicht (7), eine Abstimmschicht (3) und eine dazwischen befindliche Zentralschicht (5) bezüglich der Schichtebenen transversal zueinander angeordnet sind,
bei der für getrennte Strominjektion in diese aktive Schicht (7) und in diese Abstimmschicht (3) Kontakte (12, 13, 16) vorhanden sind, von denen je ein Kontakt elektrisch leitend mit dieser aktiven Schicht (7), mit dieser Zentralschicht (5) und mit dieser Abstimmschicht (3) verbunden ist,
bei der die Abstimmschicht (3) eine mehrlagige Quantum-Well-Schichtstruktur besitzt,
bei der eine weitere Schicht einen Stegwellenleiter (9) bildet,
bei der zwischen den aufgeführten Schichten und dem Substrat (1) ein dotierter Bereich (20) vorhanden ist, der auf einen schmalen Streifen unterhalb der Abstimmschicht (3) und der aktiven Schicht (7) begrenzt ist,
bei der auf diesem dotierten Bereich (20) lateral zu der Abstimmschicht (3) und der aktiven Schicht (7) ein weiterer dotierter Bereich (17) vorhanden ist,
bei der der mit der zwischen der Zentralschicht (5) und dem dotierten Bereich (20) angeordneten Schicht elektrisch leitend verbundene Kontakt (16) auf der dem Substrat (1) abgewandten Seite dieses weiteren dotierten Bereiches (17) aufgebracht ist und
bei der ein Graben (18) vorhanden ist, der diesen weiteren dotierten Bereich (17) von den restlichen Schichten elektrisch isoliert.

2. Laserdiode nach Anspruch 1,
bei der der dotierte Bereich (20) durch eine in das Substrat (1) eingebettete Pufferschicht gebildet ist.

3. Laserdiode nach Anspruch 1 oder 2,
bei der zwischen der Abstimmschicht (3) und der Zentralschicht (5) und zwischen der aktiven Schicht (7) und der Zentralschicht (5) je eine Zwischenschicht (4, 6) zur Anpassung von Gitterstruktur und Dotierungshöhe vorhanden ist.

4. Laserdiode nach einem der Ansprüche 1 bis 3,
bei der eine dotierte DFB-Gitterschicht (8) vertikal an die aktive Schicht (7) angrenzend vorhanden ist.

5. Laserdiode nach einem der Ansprüche 1 bis 4,
bei der die Abstimmschicht (3) auf der dem Substrat (1) abgewandten Seite der Zentralschicht (5) angeordnet ist.

6. Laserdiode nach einem der Ansprüche 1 bis 5,
bei der der Graben (18) mit einer Passivierungsschicht (11) versehen ist.

## Claims

1. Tunable laser diode,
in which an active layer (7), a tuning layer (3) and a central layer (5) situated therebetween are disposed transversely to one another with respect to the layer planes on a substrate (1) of semi-insulating semiconductor material,
in which contacts (12, 13, 16) are provided for separate current injection into this active layer (7) and into this tuning layer (3), of which contacts in each case one contact is electrically conductively connected to this active layer (7), to this central layer (5) and to this tuning layer (3),
in which the tuning layer (3) possesses a multilayer quantum-well layer structure,
in which a further layer forms a ridge waveguide (9),
in which a doped region (20) is provided between said layers and the substrate (1), which region is limited to a narrow strip below the tuning layer (3) and the active layer (7),
in which a further doped region (17) is provided on this doped region (20) laterally to the tuning layer (3) and the active layer (7),
in which the contact (16) electrically conductively connected to the layer disposed between the central layer (5) and the doped region (20) is applied to that side of this further doped region (17) which is remote from the substrate (1), and
in which a trench (18) is provided, which electrically insulates this further doped region (17) from the remaining layers.

2. Laser diode according to Claim 1,
in which the doped region (20) is formed by a buffer layer embedded in the substrate (1).

3. Laser diode according to Claim 1 or 2,
in which in each case one intermediate layer (4, 6) for the matching of grating structure and doping height is provided between the tuning layer (3) and the central layer (5) and between the active layer (7) and the central layer (5).

4. Laser diode according to one of Claims 1 to 3,
in which a doped DFB grating layer (8) is provided, vertically adjoining the active layer (7).

5. Laser diode according to one of Claims 1 to 4,
in which the tuning layer (3) is disposed on that side of the central layer (5) which is remote from the substrate (1).

6. Laser diode according to one of Claims 1 to 5,
in which the trench (18) is provided with a passivation layer (11).

## Revendications

1. Diode laser accordable, dans laquelle une couche active (7), une couche d'accord (3) et une couche centrale (5) interposée entre ces deux couches, sont placées sur un substrat (1) en matériau semiconducteur, semi-isolant, disposées les unes par rapport aux autres, transversalement pour ce qui concerne les plans des couches
dans laquelle il est prévu, pour une injection séparée de courant dans cette couche active (7) et dans cette couche d'accord (3), des contacts (12,13,16) dont chacun respectivement est relié de manière à conduire l'électricité à la couche active (7), à la couche centrale (5) et à la couche d'accord (3),
dans laquelle la couche d'accord (3) a une structure de puits quantiques à plusieurs couches,
dans laquelle une couche supplémentaire forme un guide d'onde à moulure,
dans laquelle il est prévu entre les couches mentionnées et le substrat (1), une zone dopée (20), qui est limitée à une bande étroite sous la couche d'accord (3) et la couche active (7),
dans laquelle il est prévu une autre zone dopée (17), qui est située sur cette zone dopée (20) et à côté de la couche d'accord (3) et de la couche active (7),
dans laquelle le contact (16) relié, de manière à conduire l'électricité, à la couche située entre la couche centrale (5) et la zone dopée (20) est déposé sur le côté éloigné du substrat, de l'autre zone dopée (17) et
dans laquelle il existe un sillon (18) qui isole électriquement cette autre zone dopée (17) des couches restantes.

2. Diode laser selon la revendication 1,
dans laquelle la zone dopée (20) est formée d'une couche tampon noyée dans le substrat (1).

3. Diode laser selon la revendication 1 ou 2,
dans laquelle il est prévu
entre la couche d'accord (3) et la couche centrale (5) et entre la couche active (7) et la couche centrale (5), respectivement une couche intermédiaire (4,6) destinée à adapter la structure réticulaire et la hauteur de dopage.

4. Diode laser selon l'une des revendications 1 à 3,
dans laquelle il est prévu une couche réticulée DFB (8) dopée adjacente verticalement à la couche active (7).

5. Diode laser selon l'une des revendications 1 à 4,
dans laquelle la couche d'accord (3) est placée du côté de la couche centrale (5), qui est éloigné du substrat (1).

6. Diode laser selon l'une des revendications 1 à 5,
dans laquelle le sillon (18) est muni d'une couche de passivation.
